# FASCICULE DE BREVET EUROPEEN

(11) **EP 2 884 532 B1**
(45) Date de publication et mention de la délivrance du brevet: **24.03.2021**
(21) Numéro de dépôt: 14191483.8
(22) Date de dépôt: 03.11.2014
(51) Int. Cl.: H01L 23/498, H01L 21/48

(54) **Procédé de fabrication d'un organe électriquement conducteur pour composant électronique présentant une extrémité munie d'une cavité**
Herstellungsverfahren eines elektrisch leitenden Organs für elektronisches Bauteil, das an einem Ende mit einem Hohlraum ausgestattet ist
Method for manufacturing an electrically conductive member for an electronic component having one end provided with a cavity

(30) Priorité: 08.11.2013 FR 1360934
(43) Date de publication de la demande: 17.06.2015
(73) Titulaire: COMMISSARIAT À L'ÉNERGIE ATOMIQUE ET AUX ÉNERGIES ALTERNATIVES, 75015 Paris (FR)
(72) Inventeur: Brun, Jean, 38800 Champagnier (FR); Hassaine, Abdelhak, 38100 Grenoble (FR); Quemper, Jean-Marie, 38950 Saint-Martin-Le-Vinoux (FR); Taillefer, Régis, 38420 Le Versoud (FR)
(74) Mandataire: Novaimo

(56) Documents cités:
- US-A- 5 929 521
- US-A1- 2013 001 767

## Description

### Domaine technique de l'invention

L'invention concerne le domaine de l'électronique et plus particulièrement la connectique dans le domaine de la microélectronique.

En particulier, un objet de l'invention concerne un procédé de fabrication d'un organe électriquement conducteur pour composant électronique.

### État de la technique

Dans le cadre de la connexion d'éléments électroniques entre eux, il est connu d'utiliser des plots pénétrants favorisant un bon contact électrique avec un élément électriquement conducteur correspondant.

Le document FR2967296 décrit en ce sens un système de connexion utilisant un organe mâle et un organe femelle. Bien que performant, ce système de connexion requiert une grande précision lors de l'accouplement de l'organe mâle avec l'organe femelle afin de ne pas détériorer l'un desdits organes.

Le document FR2928033 est une alternative dans laquelle un insert est formé par un cylindre creux coupé selon un biseau afin de faciliter sa pénétration dans un organe tiers tout en évitant d'emprisonner de l'air. La même problématique que celle énoncée pour le document FR2967296 s'applique.

En outre, les procédés de fabrication des systèmes de connexion décrits ci-avant sont difficiles à maitriser du fait de la fragilité de l'insert ou de l'organe.

Le document US2013/0001767 décrit un composant comprenant des plots de connexion surmontés de restes d'un matériau sacrificiel servant de matériau de collage.

Le document US5929521 décrit des structures comprenant des conformations prévues pour recevoir des billes de soudure destinées à assurer des connexions électriques.

### Objet de l'invention

L'invention est définie par les revendications indépendantes, les réalisations préférées sont définies par les revendications dépendantes.

Le but de la présente invention est de proposer une fabrication aisée d'un organe électriquement conducteur et dont la résistance aux sollicitations mécaniques est plus élevée.

On tend vers ce but grâce à un procédé de fabrication d'un organe électriquement conducteur pour composant électronique, ledit procédé comportant les étapes suivantes : la fourniture d'une structure comprenant au moins un trou borgne comportant un fond et au moins un flanc latéral intérieur relié audit fond par une base dudit flanc latéral ; la formation de l'organe comprenant une étape de croissance d'un matériau électriquement conducteur pour former au moins une partie de l'organe dans le trou borgne, ladite croissance étant plus importante au niveau de la base du flanc latéral du trou borgne qu'au niveau du reste dudit flanc latéral, ledit organe formé comportant une cavité agencée à une extrémité dudit organe disposée à l'opposé du fond du trou borgne, ladite cavité étant en tout ou partie bordée par un rebord.

Par exemple, l'étape de croissance met en œuvre une étape d'électrolyse ou une étape de dépôt chimique.

Selon une réalisation, l'étape de fourniture de la structure comprenant ledit au moins un trou borgne comporte les étapes suivantes : fournir un substrat ; former un masque sur le substrat de sorte que ledit masque délimite ledit au moins un trou borgne avec ledit substrat.

Selon une réalisation particulière, tout ou partie du fond du trou borgne, et/ou au moins la base du flanc latéral sont formés par un matériau, se présentant notamment sous la forme d'une couche, apte à favoriser ladite croissance.

Par exemple, le fond du trou borgne, au moins dans une partie centrale, est formé par une couche d'un matériau empêchant ladite croissance.

Avantageusement, le fond du trou borgne est formé par un matériau apte à permettre une croissance de l'organe par électrolyse, et l'étape de formation de l'organe comporte, avant l'étape de croissance, une étape de pulvérisation d'une partie du matériau apte à permettre la croissance de l'organe par électrolyse sur au moins la base du flanc latéral intérieur du trou borgne, et l'étape de croissance est réalisée par électrolyse après l'étape de pulvérisation.

L'étape de pulvérisation peut comporter l'application d'un plasma, ou la réalisation d'une gravure ionique.

Avantageusement, l'étape d'électrolyse est réalisée à partir de nickel, ou d'or, ou de cuivre, ou d'étain, ou un alliage d'au moins deux de ces derniers.

De préférence, l'étape de formation de l'organe comporte, après la croissance de la partie de l'organe, une étape de formation d'un empilement d'une ou plusieurs couches à partir de ladite partie de l'organe afin de former le reste dudit organe de telle sorte que le sommet de l'empilement délimite ladite cavité.

Le procédé peut en outre comporter une étape de libération de l'organe comprenant le retrait de tout ou partie de la structure.

L'invention concerne aussi un composant électronique comprenant un support et un organe électriquement conducteur muni d'une première extrémité et d'une deuxième extrémité opposée à la première extrémité, ladite deuxième extrémité comprenant une cavité, ledit organe s'étendant du support à partir de sa première extrémité vers une direction opposée audit support, ledit support étant muni d'une puce électronique, et l'organe formant un plot de connexion électrique relié électriquement à la puce notamment via la première extrémité dudit organe. L'organe est muni d'une embase pleine s'étendant entre la première extrémité et le fond de la cavité. L'embase a une hauteur d'au moins 10% de la hauteur totale maximale de l'organe et un rebord borde tout ou partie de la cavité.

Selon une réalisation du composant, ledit rebord présente une forme en biseau.

Par exemple, ledit rebord comprend au moins deux tronçons de bord opposés, de préférence sensiblement parallèles

En particulier, le rebord comporte une arête formant une boucle incluse en totalité dans un plan.

Notamment, la deuxième extrémité de l'organe est en contact électrique avec un élément électriquement conducteur.

Avantageusement, l'élément électriquement conducteur est pénétré par tout ou partie du rebord de sorte à assurer un contact électrique avec ledit organe correspondant.

Notamment, le composant comporte une rainure d'encastrement d'un élément filaire électriquement conducteur, et l'organe s'étend à partir de sa première extrémité d'une première paroi latérale de la rainure formée par une partie du support, ladite deuxième extrémité de l'organe étant en regard d'une deuxième paroi latérale de la rainure d'encastrement.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- les figures 1, 2A, 2B, 3, 4, 5, 6A et 6B illustrent différentes étapes de différents procédés de fabrication de l'organe,
- les figures 7 à 9 sont des vues en perspective d'organes selon différentes réalisation de l'invention,
- la figure 10 illustre une coupe selon C1 des figures 7 à 9,
- la figure 11 illustre une réalisation particulière d'un composant électronique selon une mise en œuvre de l'invention,
- la figure 12 illustre une utilisation possible de l'organe au sein d'un composant électronique,
- la figure 13 est une vue en perspective d'une réalisation particulière du composant électronique avec rainure d'encastrement d'un élément filaire,
- la figure 14 est une vue en coupe selon C2 dans le plan de la rainure d'encastrement du composant de la figure 13.

### Description de modes préférentiels de l'invention

Le procédé de fabrication d'un organe électriquement conducteur pour composant électronique tel que décrit ci-après diffère de l'art antérieur notamment en ce qu'il permet une obtention rapide d'un organe présentant une assise de meilleure qualité. Il en résulte que l'organe est moins fragile et risque moins de rompre lorsqu'il est sollicité, notamment lors de sa pénétration dans un autre organe ou élément.

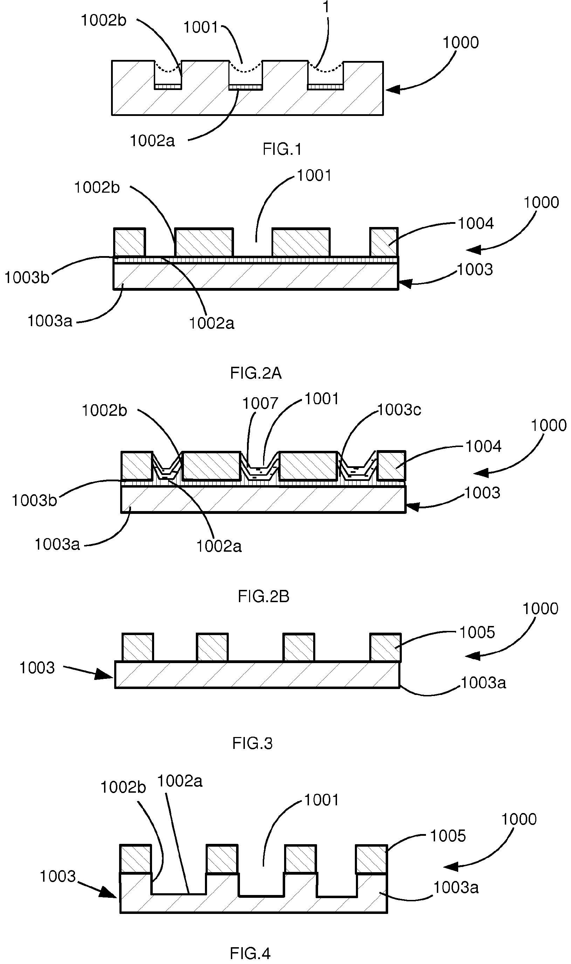

En particulier, un tel procédé peut comporter une étape dans laquelle il est fourni (figures 1 à 5) une structure 1000 comprenant au moins un (ou plusieurs) trou borgne 1001.

Un trou borgne 1001 comporte un fond 1002a et au moins un flanc latéral 1002b intérieur relié audit fond 1002a par une base dudit au moins un flanc latéral 1002b.

Le flanc latéral 1002b s'étend en fait du fond 1002a en direction d'une ouverture du trou borgne 1001 opposée audit fond 1002a. Pour un trou borgne 1001, le flanc latéral 1002b peut en fait correspondre à la surface intérieure du trou borgne qui s'étend du fond 1002a du trou borgne jusqu'à son ouverture. Le fond 1002a du trou borgne 1001 peut être délimité par une surface plane ou non.

Le procédé comporte en outre une étape de formation de l'organe 1 (représenté en pointillés à la figure 1) à partir dudit au moins un trou borgne 1001. En fait, le procédé peut aussi permettre de réaliser une pluralité d'organes, dès lors, lorsque la structure comporte une pluralité de trous borgnes 1001, chaque trou borgne 1001 va permettre de former un organe 1 correspondant tout ce qui s'applique à la formation d'un organe dans la présente description peut être mis en œuvre pour former, de préférence de manière simultanée, plusieurs organes lorsque la structure fournie comporte une pluralité de trous borgnes 1001.

En ce sens, l'étape de formation de l'organe comprend une étape croissance d'un matériau électriquement conducteur pour former au moins une partie de l'organe 1 dans le trou borgne 1001, ladite croissance étant plus importante au niveau de la base du flanc latéral 1002b du trou borgne 1001 qu'au niveau du reste dudit flanc 1002b. Notamment, l'organe formé comporte une cavité agencée à une extrémité dudit organe disposée à l'opposé du fond 1002a du trou borgne 1001, ladite cavité étant en tout ou partie bordée par un rebord.

Par « cavité » on entend préférentiellement une zone en creux disposée à une extrémité externe de l'organe, ce creux étant bordé en tout ou partie par le rebord.

Par « rebord » on entend une partie faisant saillie d'une partie correspondante de l'organe et délimitant ladite cavité. De préférence, ce rebord est biseauté.

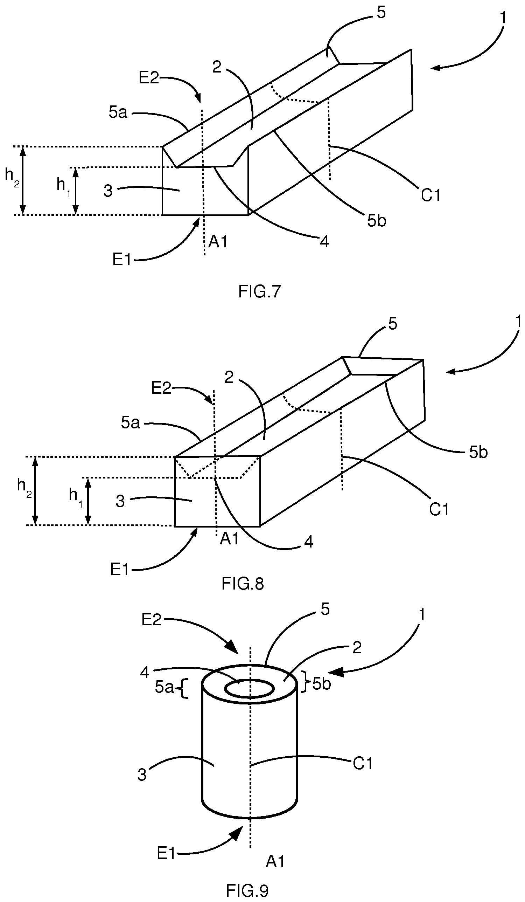

Les figures 7 à 9 permettent d'illustrer un organe 1 électriquement conducteur muni de la cavité 2. Sur ces figures 7 à 9 une embase 3 de l'organe délimite en partie un fond 4 de la cavité à partir duquel s'étend le rebord 5.

Selon une mise en œuvre particulière, l'étape de croissance met en œuvre une étape d'électrolyse ou une étape de dépôt chimique (aussi connue sous le terme anglais « electroless ». L'étape d'électrolyse peut être réalisée à partir de nickel, ou d'or, ou de cuivre, ou d'étain, ou un alliage d'au moins deux de ces derniers ou de CuAgSn. Le plomb et le platine peuvent aussi être adaptés.

A titre d'exemple, l'électrolyse à partir d'or peut être réalisée avec une densité de courant de 0,009A/cm², et pour le nickel une fois une première couche réalisée avec une densité de courant de 0,007A/cm².

Selon un mode de réalisation particulier (figures 2A à 6B), l'étape de fourniture de la structure 1000 comprenant ledit au moins un trou borgne 1001 comporte une étape de fourniture d'un substrat 1003 et une étape de formation d'un masque 1004 sur le substrat 1003 de sorte que ledit masque 1004 délimite ledit au moins un trou borgne 1001 avec ledit substrat 1003.

Selon une première variante de fourniture de la structure 1000 illustrée aux figures 2A et 2B, le substrat 1003 peut comporter une couche de silicium 1003a sur laquelle repose une couche 1003b d'un matériau apte à permettre la croissance de l'organe 1 (ce matériau pouvant être celui permettant l'électrolyse tel que visé précédemment). Le masque 1004, de préférence troué au préalable, est déposé/formé sur la couche 1003b de sorte à délimiter un ou plusieurs trous borgnes 1001 dont le fond 1002a, de préférence plan, est constitué par le matériau apte à permettre la croissance de l'organe 1. Alternativement, le masque 1004 est formé directement sur la couche 1003b du substrat 1003 par photolithographie de résine positive, par exemple de type THB820 d'une épaisseur de 20µm. L'épaisseur de la couche 1003b peut être comprise entre 100Å et 2000Å ou peut aller jusqu'à quelques micromètres.

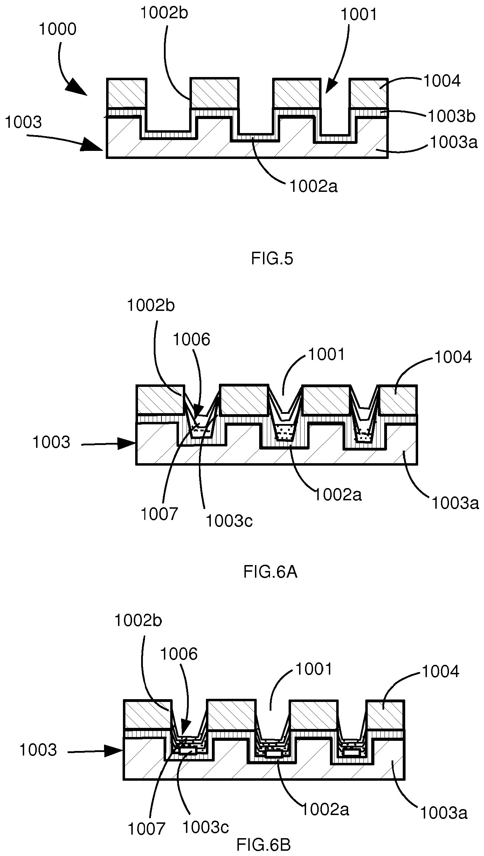

Selon une deuxième variante illustrée aux figures 3 à 5, on part d'une couche en silicium 1003a sur laquelle il est rajouté par photolithographie un premier masque sacrificiel 1005 (notamment en résine photosensible) formant un ou plusieurs trous borgnes intermédiaires avec la couche en silicium 1003a. Une étape de gravure (figure 4) permet ensuite de prolonger chacun des trous borgnes intermédiaires dans la couche en silicium 1003a. Ensuite, le premier masque sacrificiel 1005 est retiré et une couche 1003b du matériau apte à permettre la croissance de l'organe 1 est déposée par dépôt conforme de sorte à recouvrir les trous borgnes formés (figure 5) dans la couche en silicium 1003a. Enfin, un masque 1004 est formé (figure 5) de sorte que chaque trou borgne 1001 comporte un fond 1002a et la base de son flanc latéral 1002b formés par le matériau apte à permettre la croissance de l'organe 1 telle que décrite. Autrement dit, le matériau 1003b forme le fond 1002a et s'étend en direction de l'ouverture du trou borgne 1001.

Ainsi, de manière générale, tout ou partie du fond 1002a du trou borgne 1001, de préférence plan, et/ou au moins la base du flanc latéral 1002b sont formés par un matériau 1003b (notamment sous forme d'une couche) apte à favoriser la croissance dudit organe. Ceci permet notamment de réaliser la croissance de l'organe 1 de telle sorte qu'elle soit plus importante au niveau de la base du flanc latéral qu'au niveau du reste dudit flanc latéral. Par « favoriser la croissance », on entend que la croissance est plus rapide, si possible uniquement, là où ledit matériau 1003b est présent. On comprend de ce qui a été dit ci-dessus que préférentiellement au moins une partie de la surface intérieure du trou borgne, notamment formée par une partie du flanc latéral 1002b, n'est pas formée par ledit matériau favorisant la croissance.

Dans la présente description, le matériau apte à favoriser la croissance est avantageusement choisi parmi l'or ou le cuivre ou l'argent ou le palladium. De façon générale on choisira un matériau facilement repulvérisable en vue de créer un gradient en épaisseur du matériau apte à favoriser la croissance dans le trou borgne (la plus forte épaisseur du matériau sera au niveau de la base du flanc latéral du trou borgne dans une direction perpendiculaire à l'axe du trou).

Selon une réalisation particulière, l'étape de formation de l'organe 1 comporte, préférentiellement, les étapes successives suivantes : l'application d'un plasma de préférence à oxygène, ou la réalisation d'une gravure ionique sous incidence rasante, de sorte à modifier les propriétés du trou borgne 1001 (notamment au niveau de son fond 1002a), et une électrolyse au nickel pour faire croître l'organe à partir du trou borgne 1001. Cette étape de formation de l'organe est préférentiellement utilisée lorsque l'on est dans le cadre de la première variante de fourniture de la structure 1000 (figure 2A).

Le plasma à oxygène peut aussi être remplacé par d'autres gaz réactifs comme le SF6.

En fait, le plasma d'oxygène permet de pulvériser (ou repulvériser dans le cas où le dépôt du matériau apte à favoriser la croissance a été obtenu préalablement par pulvérisation) le fond 1002a du trou borgne 1001 pour former, sur la base du flanc latéral 1002b du trou borgne 1001, un dépôt conducteur à base de métal issu du matériau apte à favoriser la croissance de l'organe et ainsi former un gradient en épaisseur dudit matériau. Dans la plupart des cas, le dépôt est d'autant plus épais (et donc conducteur) qu'il est proche de la surface de la matrice (le fond 1002a formant la matrice). A distance de la matrice, le dépôt devient de plus en plus fin et peut être constitué de simples îlots. Selon une mise en œuvre particulière de l'étape d'application du plasma d'oxygène sur un équipement adapté comme par exemple un NEXTRAL330, les conditions sont les suivantes :
Puissance : 250 W
- Gaz utilisés : O₂ à 140 sccm et Ar à 20 sccm,
- Pression : 100 mTorr
- durée 30 secondes.

Ensuite, au cours de l'électrolyse consécutive au plasma à oxygène, les résidus métalliques pulvérisés sur le flanc du trou borgne sont connectés électriquement au fond du trou borgne. La vitesse de dépôt électrolytique est alors être proportionnelle à la quantité de courant qui passe. Comme les résidus métalliques n'ont pas une résistance uniforme puisqu'ils sont plus conducteurs en bas qu'en haut, alors la vitesse de croissance sera moins importante lorsque l'on s'éloigne de la matrice de sorte à former naturellement le rebord et la cavité associée. Ensuite, lorsque l'épaisseur de métal est devenue suffisante, la vitesse de croissance du dépôt se fait conformément à la surface de base et la forme initiale est conservée tout au long de la croissance.

Selon une alternative visible à la figure 6B mettant en œuvre la gravure ionique sous incidence rasante, cette dernière permet de pulvériser un matériau isolant 1003c provenant avantageusement du flanc du masque 1004 définissant le motif du trou (ou repulvériser ledit matériau isolant dans le cas où le masque a été obtenu préalablement par pulvérisation) le matériau pulvérisé se déposant sur une partie centrale du fond du trou borgne. Cette gravure ionique est réalisée par exemple à l'argon ou à l'oxygène. Un résidu isolant présentant un gradient d'épaisseur plus ou moins poreux se forme au centre du fond du trou borgne (épaisseur plus importante au centre du résidu qu'à sa périphérie), laissant une zone électriquement conductrice en périphérie du fond. Dans le cas de la gravure ionique, l'électrolyse s'amorçant préférentiellement à partir des surfaces conductrices, le dépôt va démarrer à la périphérie du fond du trou borgne, puis le résidu poreux se disloque au cours de l'électrolyse en commençant par les zones les moins épaisses et permet la croissance du matériau depuis la périphérie du fond du trou borgne en s'étendant progressivement vers le centre créant une croissance électrolytique non uniforme.

Plus généralement, lorsque le fond 1002 du trou borgne 1001 est formé par un matériau apte à permettre une croissance de l'organe par électrolyse, l'étape de l'application du plasma ou de la réalisation de la gravure ionique peut être généralisée par le fait que l'étape de formation de l'organe comporte, avant l'étape de croissance, une étape de pulvérisation d'une partie du matériau apte à permettre la croissance de l'organe par électrolyse (notamment par électrolyse au nickel) sur au moins la base du flanc latéral intérieur 1002b du trou borgne 1001, et l'étape de croissance est réalisée par électrolyse (notamment par électrolyse au nickel) après l'étape de pulvérisation.

Préférentiellement, l'étape de pulvérisation peut comporter l'application d'un plasma, ou la réalisation d'une gravure ionique.

Par exemple, dans le cas de l'étape de pulvérisation, le matériau apte à permettre la croissance de l'organe par électrolyse peut être un matériau dont le seuil de pulvérisation est inférieur à un seuil prédéterminé (par exemple 50 à 100eV pour un matériau à base d'argent avec comme gaz l'argon) pour un gaz donné comme l'argon, des matériaux comme l'argent, l'or, le cuivre et le palladium sont des bons candidats.

En particulier, dans le cadre de la première variante, sur la figure 2B, le matériau 1003b apte à favoriser l'électrolyse - donc la croissance de l'organe - est repulvérisé sous forme d'une fine (quelques nanomètres à quelques dizaines de nanomètres) partie de couche 1003c électriquement conductrice sur le flanc latéral 1002b du trou borgne initial (figure 2A) de sorte à présenter un gradient d'épaisseur allant en diminuant du fond du trou vers le bord extérieur du trou, (cette fine couche pouvant ou non atteindre le bord dudit trou). Autrement dit, le matériau favorisant la croissance peut remonter sur les parois du masque 1004 en direction de l'ouverture du trou borgne. Ensuite, l'électrolyse permet de faire croître une ou plusieurs couches supplémentaires 1007 en vue d'obtenir l'organe électriquement conducteur. Ce principe s'applique aussi à la figure 6B où l'on retrouve la formation de la partie de couche 1003c et les couches supplémentaires 1007. Bien que non représenté, le même principe peut s'appliquer au fond 1002a de la figure 1 qui est formé par le matériau favorisant l'électrolyse.

Selon une variante, le fond 1002 du trou borgne 1001, au moins dans une partie centrale, est formé par une couche 1003b d'un matériau empêchant ladite croissance (ceci permettant au reste de la surface intérieure du trou borgne de favoriser ladite croissance de l'organe). Dans ce cas, la vitesse de croissance est uniforme par contre le masquage d'une partie du trou permet aussi de favoriser cette croissance dans les zones non masquées et il en résulte donc que la croissance est plus importante au niveau de la base du flanc latéral du trou borgne qu'au niveau du reste dudit flanc latéral.

Ainsi, selon la variante il est possible de masquer une partie du fond pour permettre la croissance en dehors du masque.

Alternativement, et de manière combinable avec la variante décrite ci-dessus, il est possible de pulvériser ou de repulvériser le matériau permettant la croissance pour modifier les propriétés du matériau dans une zone 1003c de la figure 6B (voir l'alternative décrite ci-dessus où l'on pulvérise un matériau isolant 1003c) où l'on souhaite éviter la croissance.

De manière générale, les réalisations associées aux figures 6A et 6B peuvent aussi être appliquées dans le cas de trou(s) borgne(s) tel que visible aux figures 2A et 2B.

On comprend de ce qui a été dit ci-dessus que l'organe peut être formé en tout ou partie par l'étape de croissance. Lorsque seule une partie de l'organe est formée par l'étape de croissance, l'étape de formation de l'organe peut comporter, après la croissance de ladite partie de l'organe, une étape de formation d'un empilement 1006 d'une ou plusieurs couches 1007 (figures 2B, 6A, 6B) à partir de ladite partie de l'organe afin de former le reste dudit organe de telle sorte que le sommet de l'empilement délimite ladite cavité.

Par exemple, pour illustrer cette réalisation à base d'empilement, le fond 1002a et au moins une partie du flanc latéral 1002b (figure 6A) intérieur du trou borgne 1001 peuvent formés par le matériau favorisant la croissance de l'organe. Dans ce cas, l'étape de formation de l'organe comporte dans un premier temps une modification de la forme du fond du trou borgne et de ladite au moins une partie du flanc latéral 1002b intérieur (formant la base visée ci-avant), notamment par électrolyse de nickel. Cette modification permet de former une amorce de la forme générale de l'organe. Dans un deuxième temps, il est réalisé la formation d'un empilement 1006 d'une ou plusieurs couches 1007 à partir de l'amorce.

De préférence, le procédé comporte une étape de libération de l'organe 1 comprenant le retrait de tout ou partie de la structure 1000. Le substrat peut constituer un support d'un composant électronique, ou l'organe peut être complétement libéré de sorte à être disposé sur un support d'un composant électronique distinct du substrat ayant permis son obtention.

Il résulte de ce qui a été dit précédemment que l'invention est aussi relative à un organe électriquement conducteur pour composant électronique obtenu par le procédé tel que décrit précédemment. L'organe comprend alors une première extrémité E1 et une deuxième extrémité E2 opposée à la première extrémité E1, ladite deuxième extrémité comportant la cavité 2 (figures 7 à 10).

En outre, l'invention est aussi relative à un organe électriquement conducteur 1 pour composant électronique s'étendant entre une première extrémité E1, destinée à être en contact avec un support, et une deuxième extrémité E2 opposée à la première extrémité E1. Cet organe 1, préférentiellement obtenu selon le procédé tel que décrit ci-avant est muni d'une cavité 2 formée au niveau de la deuxième extrémité E2 et d'une embase 3 pleine s'étendant entre la première extrémité E1 et le fond 4 de la cavité 2, l'embase 3 ayant une hauteur h1 d'au moins 10% de la hauteur totale maximale h2 de l'organe 1. Un rebord 5 borde tout ou partie de la cavité 2 (figures 7 à 10). La hauteur totale maximum h₂ peut être définie comme la distance maximum séparant des points distaux des extrémités E1 et E2.

La hauteur h₁ peut être comprise entre 10% et 90% de la hauteur totale maximale h₂, et préférentiellement égale ou de l'ordre de 60% de h₂. Bien entendu, la hauteur h₁ de l'embase 3 reste compatible avec la présence de la cavité 2, autrement dit elle ne peut donc pas atteindre 100% de la hauteur h₂ de l'organe 1. De préférence, la profondeur de la cavité 2 est inférieure à la hauteur h1 de l'embase. Ces différentes dimensions de l'embase 3 permettent de lui conférer une bonne assise en vue d'éviter la dégradation de l'organe 1 lorsque ce dernier est sollicité au niveau de sa deuxième extrémité E2 alors qu'il est fixé à un support via sa première extrémité E1. Avantageusement, ces deux hauteurs h1 et h2, ainsi que la profondeur de la cavité, sont orientées selon un axe A1 passant par les deux extrémités E1 et E2.

De préférence, la hauteur totale maximale h₂ de l'organe 1 est comprise entre 3 µm et 50 µm et la hauteur h₁ est comprise entre 2 µm et 40 µm.

Selon un exemple particulier de réalisation, la hauteur h₁ est égale à 12 µm et la hauteur h₂ est égale à 18 µm.

En fait, l'organe 1 s'étend entre ses première et deuxième extrémités E1 E2 selon l'axe A1 sensiblement perpendiculaire à un plan incluant la première extrémité E1 et à un plan incluant la deuxième extrémité E2.

Comme illustré aux figures 7 à 10, le rebord 5 présente avantageusement une forme en biseau.

En particulier, ledit rebord 5 comprend au moins deux tronçons de bord 5a, 5b opposés de préférence sensiblement parallèles. Sur la figure 7, la cavité 2 est délimitée par une rainure ouverte à ses deux extrémités, le fond de la rainure constituant le fond de la cavité 2. Par ailleurs, deux pans obliques de la rainure s'étendent en divergeant à partir du fond de la rainure pour délimiter les deux tronçons de bord 5a, 5b du rebord 5.

Dans une réalisation particulière illustrée à la figure 8, la cavité 2 est délimitée par une empreinte négative d'une pyramide à sommet tronqué et dont la base possède quatre côtés formant le bord du rebord 5. Les faces de cette pyramide convergent vers la première extrémité E1. Bien que cela ne soit pas représenté l'empreinte négative pourrait aussi être à sommet non tronqué. Plus généralement, cette empreinte négative peut être assimilée à une rainure fermée à ses deux extrémités.

Aux figures 7 et 8, les deux tronçons 5a, 5b délimitent chacun avec le reste de l'organe deux portions de biseau. Ces deux portions permettent de faciliter la pénétration de l'organe 1 dans un élément tiers.

Dans une réalisation particulière illustrée à la figure 9, la cavité 2 est délimitée par une empreinte négative d'un cône à sommet tronqué et dont la base forme le bord de la cavité 2. Le cône converge vers la première extrémité E1. Bien que cela ne soit pas représenté l'empreinte négative pourrait aussi être à sommet non tronqué. Dans cette réalisation, entre ses deux extrémités E1 et E2 l'organe 1 est délimité par un cylindre et est muni d'un unique biseau en forme de boucle.

Selon une réalisation particulière le rebord 5 comporte une arête formant une boucle incluse en totalité dans un plan. On comprend alors que le rebord 5 borde toute la cavité. Dans les réalisations des figures 8 et 9, cette arête forme le bord de la cavité 2.

De préférence, la section de l'organe dans un plan de coupe sensiblement perpendiculaire à l'axe A1 peut être rectangulaire (figures 7 et 8), ovale, ou en forme de disque (figure 9), la section peut être dépendante de la forme du trou borgne associé. D'autres formes plus complexes pourraient aussi être réalisées, notamment si la section est un polygone l'empreinte négative pourra aussi être une pyramide dont la base est un polygone.

Comme évoqué ci-dessus, l'organe est électriquement conducteur, cette conductivité électrique lui permet de former un organe de connexion électrique. L'organe peut être réalisé en l'un des matériaux visés dans le procédé de fabrication.

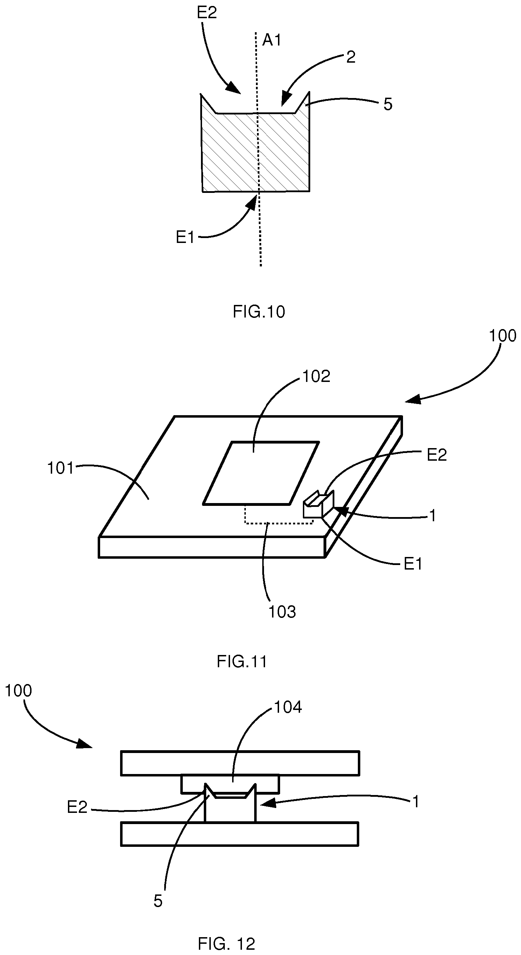

L'invention est aussi relative à un composant électronique. La figure 11 illustre un tel composant 100. Le composant électronique 100 comporte un support 101 et un organe 1 selon l'une des réalisations décrites précédemment et s'étendant du support 101 à partir de sa première extrémité E1 vers une direction opposée audit support (la deuxième extrémité E2 est donc distante du support 101). Bien entendu, le composant peut aussi comporter plusieurs organes tels que décrits.

Avantageusement, le support 101 est muni d'une puce électronique 102 et l'organe 1 forme un plot de connexion électrique relié électriquement à la puce 102 notamment via la première extrémité E1 dudit organe 1. Cette liaison électrique peut être mise en œuvre par tout type d'élément de liaison 103 tel que représenté en pointillés à la figure 11. Dans ce cas, tout ou partie de l'organe 1 peut être électriquement conducteur.

Notamment, dans la présente description, on entend par « puce électronique » toute structure électronique passive ou active comportant une ou plusieurs connexions électriques.

De préférence, la deuxième extrémité E2 de l'organe 1 est, comme illustré à la figure 12, en contact électrique avec un élément 104 électriquement conducteur du composant électronique 100. Par exemple, l'élément électriquement conducteur 104 est pénétré par tout ou partie du rebord 5 de sorte à assurer un contact électrique avec ledit organe 1 correspondant. On comprend que l'extrémité E2 de l'organe 1 permet de réaliser un contact intime avec l'élément électriquement conducteur 104.

Selon une réalisation, la cavité 2 de l'organe 1 permet avantageusement un alignement ou un centrage de l'élément 104 électriquement conducteur à associer audit organe 1.

De préférence, l'élément électriquement conducteur 104 présente une dureté inférieure à celle de l'organe 1 de sorte que l'élément électriquement conducteur 104 autorise la pénétration de l'organe 1 (notamment le rebord 5 de l'organe 1) en son sein sans dégradation dudit organe 1. Il peut aussi y avoir une dégradation partielle de l'organe et/ou de l'élément électriquement conducteur au niveau du contact entre ces deux derniers.

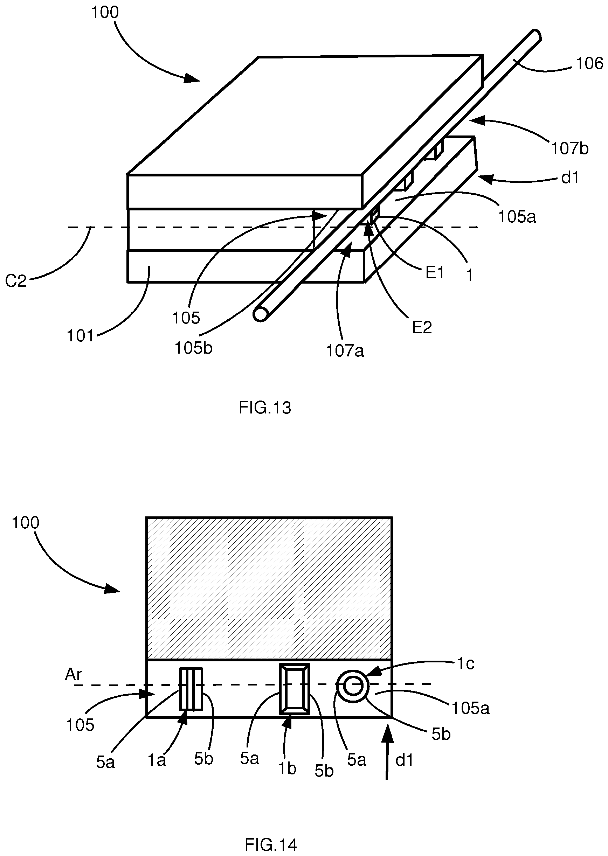

Selon une mise oeuvre particulière illustrée aux figures 13 et 14, le composant électronique 100 comporte une rainure 105 d'encastrement d'un élément filaire 106 électriquement conducteur. L'organe 1 s'étend à partir de sa première extrémité E1 d'une première paroi latérale 105a de la rainure 105 formée par une partie du support 101. La deuxième extrémité E2 de l'organe 1 est en regard d'une deuxième paroi latérale 105b de la rainure 105. Autrement dit, la deuxième paroi latérale 105b de la rainure 105 comporte au moins une partie disposée à l'aplomb de la deuxième extrémité E2. De préférence, la première paroi latérale 105a et la deuxième paroi latérale 105b sont sensiblement parallèles entre elles. La rainure 105 est avantageusement ouverte à ses deux extrémités 107a et 107b. L'espace laissé entre la deuxième extrémité E2 et la deuxième paroi latérale 105b de la rainure 105 est destiné à l'encastrement de l'élément filaire 106. Lorsqu'il est encastré, l'élément filaire 106 fait partie intégrante du composant électronique 100, il est alors assimilé à l'élément électriquement conducteur 104 visé ci-avant.

De préférence, les première et deuxième parois latérales 105a, 105b de la rainure 105 s'étendent selon un axe de rainure Aᵣ (visible à la figure 14 et sensiblement parallèle à l'élément filaire 106 représenté à la figure 13) les deux tronçons 5a, 5b opposés de l'organe 1 sont alors échelonnés le long de l'axe de rainure Aᵣ et sont perpendiculaires, ou obliques, audit axe de rainure Aᵣ. Ceci permet de faciliter la pénétration de l'organe dans l'élément filaire 106 lors de l'encastrement dudit l'élément filaire 106 dans la rainure 105 selon une direction d'encastrement latérale d1 à la rainure 105, tout en procurant à l'organe 1 une bonne résistance au cisaillement induit lors de l'encastrement grâce à l'assise procurée par son embase. Bien que les trois organes 1a, 1b, 1c représentés à la figure 14 permettent d'illustrer que les organes des figures 7 à 9 peuvent être utilisés seuls ou en combinaison, il sera préféré l'utilisation de l'organe de la figure 7 dont la cavité 2 est délimitée par une rainure ouverte facilitant l'encastrement de l'élément filaire via deux pointes d'extrémité de rainurage.

Sur la figure 13, l'élément filaire 106 est pincé entre la deuxième extrémité E2 de l'organe 1 et la paroi latérale de rainure 105b opposée à la paroi latérale de rainure 105a à partir de laquelle s'étend ledit organe 1. Bien que les forces exercées par le pincement de l'élément filaire 106 entre l'organe 1 et la paroi latérale de rainure 105b soient suffisante pour maintenir l'assemblage de l'élément filaire 106 avec le reste du composant électronique, la rainure 105 peut avantageusement être comblée par un matériau électriquement isolant, ou électriquement conducteur, destiné à renforcer ledit assemblage.

Dans la présente description, par sensiblement parallèle, on peut entendre exactement parallèle ou parallèle à plus ou moins 10 degrés.

Dans la présente description, par sensiblement perpendiculaire, on peut entendre exactement perpendiculaire ou perpendiculaire à plus ou moins 10 degrés.

II a été décrit ci-avant la possibilité d'aligner ou de centrer un élément 104 électriquement conducteur avec l'organe tel que décrit. De manière plus générale, l'organe électriquement conducteur peut également être utilisé comme outil d'alignement de tout élément tiers (qu'il soit électriquement conducteur ou non), notamment dans le domaine de la microélectronique. Un tel élément tiers peut être une bille, ou encore un élément mâle (électriquement conducteur ou non) tel que décrit dans la demande de brevet FR2967296 pénétrant dans un élément femelle formé dans le cas présent par ledit organe électriquement conducteur.

## Revendications

1. Procédé de fabrication d'un organe électriquement conducteur pour composant électronique selon la revendication 11 **caractérisé en ce qu'**il comporte les étapes suivantes :
- la fourniture d'une structure (1000) comprenant au moins un trou borgne (1001) comportant un fond (1002a) et au moins un flanc latéral (1002b) intérieur relié audit fond par une base dudit flanc latéral,
- la formation de l'organe (1) comprenant une étape de croissance d'un matériau électriquement conducteur pour former au moins une partie de l'organe (1) dans le trou borgne (1001), ladite croissance étant plus importante au niveau de la base du flanc latéral (1002b) du trou borgne (1001) qu'au niveau du reste dudit flanc latéral (1002b), ledit organe formé comportant une cavité agencée à une extrémité dudit organe disposée à l'opposé du fond (1002a) du trou borgne (1001), ladite cavité étant en tout ou partie bordée par un rebord.

2. Procédé selon la revendication précédente, **caractérisé en ce que** l'étape de croissance met en œuvre une étape d'électrolyse ou une étape de dépôt chimique.

3. Procédé selon la revendication 1 ou la revendication 2, **caractérisé en ce que** l'étape de fourniture de la structure (1000) comprenant ledit au moins un trou borgne (1001) comporte les étapes suivantes :
- fournir un substrat (1003),
- former un masque (1004) sur le substrat (1003) de sorte que ledit masque (1004) délimite ledit au moins un trou borgne (1001) avec ledit substrat (1003).

4. Procédé selon l'une des revendications précédentes, **caractérisé en ce que** tout ou partie du fond (1002a) du trou borgne (1001), et/ou au moins la base du flanc latéral (1002b) sont formés par un matériau, se présentant notamment sous la forme d'une couche, apte à favoriser ladite croissance.

5. Procédé selon l'une des revendications 1 à 4, **caractérisé en ce que** le fond (1002) du trou borgne (1001), au moins dans une partie centrale, est formé par une couche (1003b) d'un matériau empêchant ladite croissance.

6. Procédé selon l'une des revendications 1 à 5, **caractérisé en ce que** le fond (1002) du trou borgne (1001) est formé par un matériau apte à permettre une croissance de l'organe par électrolyse, et **en ce que** l'étape de formation de l'organe comporte, avant l'étape de croissance, une étape de pulvérisation d'une partie du matériau apte à permettre la croissance de l'organe par électrolyse sur au moins la base du flanc latéral intérieur du trou borgne (1001), et **en ce que** l'étape de croissance est réalisée par électrolyse après l'étape de pulvérisation.

7. Procédé selon la revendication précédente, **caractérisé en ce que** l'étape de pulvérisation comporte l'application d'un plasma, ou la réalisation d'une gravure ionique.

8. Procédé selon la revendication 2 et l'une quelconque des revendications précédentes, **caractérisé en ce que** l'étape d'électrolyse est réalisée à partir de nickel, ou d'or, ou de cuivre, ou d'étain, ou un alliage d'au moins deux de ces derniers.

9. Procédé selon l'une des revendications précédentes, **caractérisé en ce que** l'étape de formation de l'organe (1) comporte, après la croissance de la partie de l'organe, une étape de formation d'un empilement (1006) d'une ou plusieurs couches (1007) à partir de ladite partie de l'organe afin de former le reste dudit organe de telle sorte que le sommet de l'empilement délimite ladite cavité.

10. Procédé selon l'une des revendications précédentes, **caractérisé en ce qu'**il comporte une étape de libération de l'organe comprenant le retrait de tout ou partie de la structure.

11. Composant électronique (100) comprenant un support (101) et un organe (1) électriquement conducteur muni d'une première extrémité (E1) et d'une deuxième extrémité (E2) opposée à la première extrémité (E1), ladite deuxième extrémité comprenant une cavité (2), ledit organe s'étendant du support (101) à partir de sa première extrémité (E1) vers une direction opposée audit support (101), ledit support (101) étant muni d'une puce électronique (102), et l'organe (1) formant un plot de connexion électrique relié électriquement à la puce (102), notamment via la première extrémité (E1) dudit organe (1), l'organe (1) étant muni d'une embase (3) pleine s'étendant entre la première extrémité (E1) et le fond (4) de la cavité (2), l'embase (3) ayant une hauteur (h1) d'au moins 10% de la hauteur totale maximale (h2) de l'organe (1) et un rebord (5) bordant tout ou partie de la cavité (2).

12. Composant selon la revendication précédente, **caractérisé en ce que** ledit rebord (5) présente une forme en biseau.

13. Composant selon l'une des revendications 11 ou 12, **caractérisé en ce que** ledit rebord (5) comprend au moins deux tronçons de bord (5a, 5b) opposés, de préférence sensiblement parallèles.

14. Composant selon l'une des revendications 11 à 13, **caractérisé en ce que** le rebord (5) comporte une arête formant une boucle incluse en totalité dans un plan.

15. Composant selon l'une des revendications 11 à 14, **caractérisé en ce que** la deuxième extrémité (E2) de l'organe (1) est en contact électrique avec un élément électriquement conducteur (104).

16. Composant selon la revendication précédente, **caractérisé en ce que** l'élément électriquement conducteur (104) est pénétré par tout ou partie du rebord (5) de sorte à assurer un contact électrique avec ledit organe (1) correspondant.

17. Composant selon l'une des revendications 11 à 16, **caractérisé en ce qu'**il comporte une rainure d'encastrement (105) d'un élément filaire (106) électriquement conducteur, et **en ce que** l'organe s'étend à partir de sa première extrémité (E1) d'une première paroi latérale (105a) de la rainure (105) formée par une partie du support (101), ladite deuxième extrémité (E2) de l'organe (1) étant en regard d'une deuxième paroi latérale (105b) de la rainure d'encastrement (105).

## Patentansprüche

1. Verfahren zur Herstellung eines elektrisch leitenden Organs für ein elektronisches Bauteil nach Anspruch 11, **dadurch gekennzeichnet, dass** es die folgenden Schritte aufweist:
- die Bereitstellung einer Struktur (1000), die mindestens ein Sackloch (1001) enthält, das einen Boden (1002a) und mindestens eine innere Seitenflanke (1002b) aufweist, die über eine Basis der Seitenflanke mit dem Boden verbunden ist,
- das Formen des Organs (1), das einen Schritt des Wachstums eines elektrisch leitenden Materials enthält, um mindestens einen Teil des Organs (1) im Sackloch (1001) zu formen, wobei das Wachstum im Bereich der Basis der Seitenflanke (1002b) des Sacklochs (1001) stärker ist als im Bereich des Rests der Seitenflanke (1002b), wobei das geformte Organ einen Hohlraum aufweist, der an einem Ende des Organs eingerichtet ist, das entgegengesetzt zum Boden (1002a) des Sacklochs (1001) angeordnet ist, wobei der Hohlraum ganz oder teilweise von einer Randleiste umrandet wird.

2. Verfahren nach dem vorhergehenden Anspruch, **dadurch gekennzeichnet, dass** der Wachstumsschritt einen Elektrolyseschritt oder einen Schritt einer chemischen Abscheidung verwendet.

3. Verfahren nach Anspruch 1 oder Anspruch 2, **dadurch gekennzeichnet, dass** der Schritt der Bereitstellung der Struktur (1000), die das mindestens eine Sackloch (1001) enthält, die folgenden Schritte aufweist:
- Bereitstellen eines Substrats (1003),
- Formen einer Maske (1004) auf dem Substrat (1003) derart, dass die Maske (1004) das mindestens eine Sackloch (1001) mit dem Substrat (1003) begrenzt.

4. Verfahren nach einem der vorhergehenden Ansprüche, **dadurch gekennzeichnet, dass** der ganze oder ein Teil des Bodens (1002a) des Sacklochs (1001) und/oder mindestens die Basis der Seitenflanke (1002b) aus einem Material geformt werden, das insbesondere in Form einer Schicht vorliegt, die das Wachstum begünstigen kann.

5. Verfahren nach einem der Ansprüche 1 bis 4, **dadurch gekennzeichnet, dass** der Boden (1002) des Sacklochs (1001) zumindest in einem mittleren Teil von einer Schicht (1003b) eines das Wachstum verhindernden Materials geformt wird.

6. Verfahren nach einem der Ansprüche 1 bis 5, **dadurch gekennzeichnet, dass** der Boden (1002) des Sacklochs (1001) von einem Material geformt wird, das ein Wachstum des Organs durch Elektrolyse ermöglichen kann, und dass der Schritt des Formens des Organs vor dem Wachstumsschritt einen Schritt der Zerstäubung eines Teils des Materials aufweist, das das Wachstum des Organs durch Elektrolyse auf mindestens der Basis der inneren Seitenflanke des Sacklochs (1001) ermöglichen kann, und dass der Wachstumsschritt durch Elektrolyse nach dem Zerstäubungsschritt durchgeführt wird.

7. Verfahren nach dem vorhergehenden Anspruch, **dadurch gekennzeichnet, dass** der Zerstäubungsschritt das Anwenden eines Plasmas oder die Durchführung eines Ionenätzens aufweist.

8. Verfahren nach Anspruch 2 und nach einem der vorhergehenden Ansprüche, **dadurch gekennzeichnet, dass** der Elektrolyseschritt ausgehend von Nickel oder Gold oder Kupfer oder Zinn oder einer Legierung von mindestens zwei dieser letzteren ausgeführt wird.

9. Verfahren nach einem der vorhergehenden Ansprüche, **dadurch gekennzeichnet, dass** der Schritt des Formens des Organs (1) nach dem Wachstum des Teils des Organs einen Schritt des Formens eines Stapels (1006) einer oder mehrerer Schichten (1007) ausgehend von dem Teil des Organs aufweist, um den Rest des Organs derart zu formen, dass der Scheitel des Stapels den Hohlraum begrenzt.

10. Verfahren nach einem der vorhergehenden Ansprüche, **dadurch gekennzeichnet, dass** es einen Schritt der Freigabe des Organs aufweist, der das Entfernen der ganzen oder eines Teils der Struktur enthält.

11. Elektronisches Bauteil (100), das einen Träger (101) und ein elektrisch leitendes Organ (1) enthält, das mit einem ersten Ende (E1) und mit einem zweiten Ende (E2) entgegengesetzt zum ersten Ende (E1) versehen ist, wobei das zweite Ende einen Hohlraum (2) enthält, wobei das Organ sich vom Träger (101) ausgehend von seinem ersten (E1) in einer Richtung entgegengesetzt zum Träger (101} erstreckt, wobei der Träger (101) mit einem elektronischen Chip (102) versehen ist, und das Organ (1) einen elektrischen Anschlusskontakt formt, der elektrisch mit dem Chip (102) verbunden ist, insbesondere über das erste Ende (E1) des Organs (1), wobei das Organ (1) mit einem massiven Sockel (3) versehen ist, der sich zwischen dem ersten Ende (E1) und dem Boden (4) des Hohlraums (2) erstreckt, wobei der Sockel (3) eine Höhe (h1) von mindestens 10% der maximalen Gesamthöhe (h2) des Organs (1) und eine Randleiste (5) hat, die den ganzen oder einen Teil des Hohlraums (2) umrandet.

12. Bauteil nach dem vorhergehenden Anspruch, **dadurch gekennzeichnet, dass** die Randleiste (5) in Form einer Schräge vorliegt.

13. Bauteil nach einem der Ansprüche 11 oder 12, **dadurch gekennzeichnet, dass** die Randleiste (5) mindestens zwei entgegengesetzte, vorzugsweise im Wesentlichen parallele Randabschnitte (5a, 5b) enthält.

14. Bauteil nach einem der Ansprüche 11 bis 13, **dadurch gekennzeichnet, dass** die Randleiste (5) eine Kante aufweist, die eine vollständig in einer Ebene enthaltene Schleife formt.

15. Bauteil nach einem der Ansprüche 11 bis 14, **dadurch gekennzeichnet, dass** das zweite Ende (E2) des Organs (1) mit einem elektrisch leitenden Element (104) in elektrischem Kontakt ist.

16. Bauteil nach dem vorhergehenden Anspruch, **dadurch gekennzeichnet, dass** das elektrisch leitende Element (104) von der ganzen oder einem Teil der Randleiste (5) durchdrungen wird, um einen elektrischen Kontakt mit dem entsprechenden Organ (1) zu gewährleisten.

17. Bauteil nach einem der Ansprüche 11 bis 16, **dadurch gekennzeichnet, dass** es eine Einbettungsrille (105) eines elektrisch leitenden Drahtelements (106) aufweist, und dass das Organ sich ausgehend von seinem ersten Ende (E1) von einer ersten Seitenwand (105a) der von einem Teil des Trägers (101) geformten Rille (105) erstreckt, wobei das zweite Ende (E2) des Organs (1) einer zweiten Seitenwand (105b) der Einbettungsrille (105) gegenüberliegt.

## Claims

1. Process for manufacturing an electrically conductive member for an electronic component according to claim 11, **characterized in that** it comprises the following steps:
- providing a structure (1000) comprising at least one blind hole (1001) having a bottom (1002a) and at least one internal lateral flank (1002b) connected to said bottom via a base of said lateral flank;
- forming the member (1), this forming step comprising a step of growing an electrically conductive material in order to form at least one portion of the member (1) in the blind hole (1001), said growth being faster at the base of the lateral flank (1002b) of the blind hole (1001) than on the rest of said lateral flank (1002b), said member when formed comprising a cavity arranged at that end of said member which is located opposite the bottom (1002a) of the blind hole (1001), said cavity being entirely or partially bordered by a rim.

2. Process according to the preceding claim, **characterized in that** the growth step involves an electrolysis step or a chemical deposition step.

3. Process according to claim 1 or claim 2, **characterized in that** the step of providing the structure (1000) comprising said at least one blind hole (1001) comprises the following steps:
- providing a substrate (1003);
- forming a mask (1004) on the substrate (1003) so that said mask (1004) bounds with said substrate (1003) said at least one blind hole (1001).

4. Process according to one of the preceding claims, **characterized in that** all or some of the bottom (1002a) of the blind hole (1001), and/or at least the base of the lateral flank (1002b) are formed by a material, especially taking the form of a layer, apt to promote said growth.

5. Process according to one of claims 1 to 4, **characterized in that** the bottom (1002) of the blind hole (1001), at least in a central portion, is formed by a layer (1003b) of a material that prevents said growth.

6. Process according to one of claims 1 to 5, **characterized in that** the bottom (1002) of the blind hole (1001) is formed by a material apt to enable the member to be grown by electrolysis, and **in that** the step of forming the member comprises, before the growth step, a step of sputtering some of the material apt to enable the member to be grown by electrolysis onto at least the base of the internal lateral flank of the blind hole(1001), and **in that** the growth step is carried out by electrolysis after the sputtering step.

7. Process according to the preceding claim, **characterized in that** the sputtering step comprises applying a plasma or carrying out ion etching.

8. Process according to claim 2 and any one of the preceding claims, **characterized in that** the electrolysis step is based on nickel or gold or copper or tin or an alloy of at least two of these metals.

9. Process according to one of the preceding claims, **characterized in that** the step of forming the member (1) comprises, after the portion of the member has been grown, a step of forming a stack (1006) of one or more layers (1007) on said portion of the member in order to form the rest of said member in such a way that the top of the stack bounds said cavity.

10. Process according to one of the preceding claims, **characterized in that** it comprises a step of freeing the member, comprising removing all or some of the structure.

11. Electronic component (100) comprising a carrier (101) and an electrically conductive member (1) equipped with a first end (E1) and a second end (E2) opposite the first end (E1), said second end comprising a cavity (2), said member extending from the carrier (101) starting from its first end (E1) in a direction opposite to said carrier (101), said carrier (101) being equipped with an electronic chip (102), the member (1) forming an electrical connection pad that is electrically connected to the chip (102) especially via the first end (E1) of said member (1), wherein the member (1) is equipped with a solid body (3) extending between the first end (E1) and the bottom (4) of the cavity (2), the body (3) having a height (h1) of at least 10% of the maximum total height (h2) of the member (1), and wherein a rim (5) borders all or some of the cavity (2).

12. Component according to the preceding claim, **characterized in that** said rim (5) has a bevelled shape.

13. Component according to one of claims 11 or 12, **characterized in that** said rim (5) comprises at least two opposite and preferably substantially parallel side sections (5a, 5b).

14. Component according to one of claims 11 to 13, **characterized in that** the rim (5) comprises an edge forming a ring entirely contained in a plane.

15. Component according to one of claims 11 to 14, **characterized in that** the second end (E2) of the member (1) makes electrical contact with an electrically conductive element (104).

16. Component according to the preceding claim, **characterized in that** the electrically conductive element (104) is penetrated by all or some of the rim (5) so as to ensure electrical contact with said corresponding member (1).

17. Component according to one of claims 11 to 16, **characterized in that** it comprises a groove for anchoring (105) an electrically conductive wire element (106), and **in that** the member extends starting from its first end (E1) from a first side wall (105a) of the groove (105) formed by a portion of the carrier (101), said second end (E2) of the member (1) facing a second side wall (105b) of the anchoring groove (105).
